# EUROPÄISCHE PATENTSCHRIFT

(11) **EP 1 932 191 B1**
(45) Veröffentlichungstag und Bekanntmachung des Hinweises auf die Patenterteilung: **23.02.2011**
(21) Anmeldenummer: 06818014.0
(22) Anmeldetag: 29.09.2006
(51) Int. Cl.: H01L 41/107

(54) **Piezoelektrischer Transformator**
Piezoelectric Transformer
Transformateur Piézo-Electrique

(30) Priorität: 04.10.2005 DE 102005047368
(43) Veröffentlichungstag der Anmeldung: 18.06.2008
(73) Patentinhaber: EPCOS AG, 81669 München (DE)
(72) Erfinder: FLORIAN, Heinz, A-8524 Bad Gams (AT); GABL, Reinhard, A-8542 St. Peter (AT); KARTASHEV, Igor, A-8530 Deutschlandsberg (AT); SCHMIDT-WINKEL, Patrick, A-8524 Bad Gams (AT)
(74) Vertreter: Epping - Hermann - Fischer
(86) Internationale Anmeldenummer: PCT/DE2006/001737
(87) Internationale Veröffentlichungsnummer: WO 2007/038914

(56) Entgegenhaltungen:
- JP-A- 11 168 247
- JP-A- 2000 114 614
- JP-A- 2005 217 259
- US-A- 5 341 061
- US-A- 5 872 419
- US-A1- 2001 028 206

## Beschreibung

Die Erfindung betrifft einen piezoelektrischen Transformator mit einem Körper, der ein piezoelektrisches Material enthält.

Aus der Druckschrift US 2001/0028206 A1 ist ein piezoelektrischer Transformator bekannt, bei dem im Innern eines Körpers Innenelektroden vorgesehen sind.

In der Druckschrift US 6,794,796 B2 sind piezoelektrische Hochspannungstransformatoren des Rosen-Typs beschrieben, die Sensor-Elektroden aufweisen.

Aus den Druckschriften US 5,341,061 A und JP 2000-114614 A sind weitere piezoelektrische Transformatoren bekannt.

Eine zu lösende Aufgabe besteht darin, einen weiteren piezoelektrischen Transformator anzugeben, bei dem die Gefahr von Spannungsüberschlägen zwischen verschiedenen elektrischen Polen reduziert ist.

Diese Aufgabe wird erfindungsgemäß durch einen Transformator mit den Merkmalen des Anspruchs 1 gelöst.

Hierbei wird unter dem inversen piezoelektrischen Effekt verstanden, dass die piezoelektrische Keramik, die gegebenenfalls zum Einsatz des Bauelementes noch polarisiert werden muss, bei Anlegen eines elektrischen Feldes parallel oder antiparallel oder auch in einem Winkel zur Polarisierungsrichtung eine Verformung erfährt. Unter dem direkten piezoelektrischen Effekt wird verstanden, dass in dem Körper bei Auftreten von Verformungen eine Spannung abfällt.

Im Eingangsteil des Transformators werden mit Hilfe elektrischer Spannungen mechanische Schwingungen im Körper des Transformators erzeugt. Im Ausgangsteil werden mechanische Schwingungen des Körpers in elektrische Felder umgewandelt, welche durch geeignete Elektroden abgegriffen werden können.

Mindestens ein Teil der Hilfselektrode, in einer Variante sogar die ganze Hilfselektrode kann auch auf der Oberfläche des Grundkörpers angeordnet und als Hilfskontakt geeignet sein.

Weitere vorfeilhafte Ausführungsformen sind durch die abhängigen Ansprüche 2 bis 11 angegeben.

Im Weiteren werden vorteilhafte Ausgestaltungen des angegebenen Piezotransformators sowie seine Funktionsweise näher erläutert.

Die Innenelektroden des Ein- und Ausgangsteils sind an Ein- und Ausgangskontakte des Transformators angeschlossen, die von außen zugänglich sind. Eine innen liegende Hilfselektrode ist mit mindestens einem von außen zugänglichen Hilfskontakt des Transformators leitend verbunden.

Die Ein- und Ausgangskontakte stehen in Kontakt mit dem Grundkörper, wobei sie vorzugsweise auf seiner Oberfläche angeordnet sind. Vorzugsweise sind alle Außenkontakte des Transformators, darunter seine Ein- und Ausgangskontakte und der Hilfskontakt, lötbar.

Beim Anlegen einer Spannung an den Eingangskontakten kann eine mechanische Verformung des Körpers hervorgerufen werden. Mit Hilfe der Ausgangskontakten kann eine bei Verformung des Körpers auftretende elektrische Spannung abgegriffen werden.

Der Transformator kann mittels einer Treiberschaltung angetrieben werden, wobei an seine Eingangskontakte eine Eingangsspannung angelegt wird. Der Transformator zeichnet sich dadurch aus, dass die an seinen Ausgangskontakten abzugreifende Ausgangsspannung von der Eingangsspannung verschieben ist. Insbesondere kann die Ausgangsspannung größer sein als die Eingangsspannung. Die Ausgangsspannung kann aber auch kleiner sein als die Eingangsspannung. Der Transformator zeichnet sich außerdem vorzugsweise dadurch aus, dass eine am Hilfskontakt abzugreifende Steuerspannung sich von der Ein- und Ausgangsspannung des Transformators unterscheidet. Diese Steuerspannung kann in einer Rückkopplungsschaltung zur Überwachung der Treiberschaltung benutzt werden, durch die der Transformator angetrieben wird. Dadurch, dass die Hilfselektrode sowohl vom Eingangsteil als auch vom Ausgangsteil des Transformators galvanisch entkoppelt ist, kann in der Rückkopplungsschaltung zur Ansteuerung des Transformators auf kostenintensive Entkopplungselemente wie z. B. Optokoppler verzichtet werden.

Im Folgenden wird eine beispielhafte Ansteuerung des Transformators mittels einer Rückkopplungsschleife erläutert.

Die Hilfselektrode des Transformators bildet einen Hilfsausgang. Das Verhältnis der am Hilfsausgang abgegriffenen Spannung zur Eingangsspannung wird im Folgenden als ein Übertragungskoeffizient des Transformators bezeichnet. Die Spannung am Hilfsausgang ist im Wesentlichen proportional zur Ausgangsspannung des Transformators.

Der Eingangsteil des Transformators ist an einen Primärpfad und sein Ausgangsteil an einen Sekundärpfad angeschlossen. Die an den Eingangsteil des Transformators anzulegende Eingangsspannung wird von einem HF-Generator geliefert, der eine im Primärpfad angeordnete Schaltung mit einem Oszillator, einem Treiber und einem oder mehreren Schaltern umfassen kann. Der Treiber ist z. B. zur Ansteuerung der Schalter geeignet. Der Oszillator kann insbesondere ein spannuhgsgesteuerter Oszillator - Voltage Control Oscillator - sein. Der Oszillator ist z. B. über den Treiber mit dem Schalter oder den Schaltern verbunden.

Zwischen dem Hilfsausgang und einem Treibereingang des HF-Generators ist ein Rückkopplungspfad mit einer darin angeordneten Rückkopplungsschaltung vorgesehen. Der Rückkopplungspfad kann in einer vorteilhaften Variante sowohl vom Primärals auch vom Sekundärteil galvanisch entkoppelt sein. Die Rückkopplungsschaltung kann z. B. einen Komparator, einen Verstärker und/oder weitere Elemente zur Verarbeitung eines an der Hilfselektrode abgegriffenen Rückkopplungssignals zu einem Steuersignal umfassen, das am Treibereingang des HF-Generators ankommt und den Oszillator des HF-Generators ansteuert, wodurch insbesondere die Frequenz des Oszillators eingestellt werden kann.

Durch die Anpassung der Frequenz der Eingangsspannung ist es insbesondere möglich, die Ausgangsspannung des Transformators konstant zu halten. Dies ist mit Hilfe der Rückkopplungsschleife möglich, wobei der in einer Variante frequenzabhängige Übertragungskoeffizient des Transformators durch die Frequenz der Eingangsspannung beeinflusst werden kann.

Der angegebene Piezotransformator weist vorzugsweise eine Resonanzcharakteristik auf, d. h. sein Übertragungskoeffizient wird durch eine Resonanzkurve charakterisiert. Der Arbeitspunkt des Transformators kann z. B. an der linken oder rechten Flanke seiner Resonanzkurve, also unterhalb oder oberhalb seiner Resonanzfrequenz gewählt sein.

Falls am Hilfsausgang des Transformators eine Abweichung der Spannung vom Arbeitspunkt festgestellt wird, wird diese Spannungsdifferenz mittels der Rückkopplungsschaltung zu einem Steuersignal zur Ansteuerung des Treibers des HF-Generators verarbeitet, wobei die Frequenz der Eingangsspannung derart geändert wird, um der Spannungsabweichung entgegen zu wirken. Dabei verschiebt sich auch der Arbeitspunkt des Transformators. Beispielsweise um einen Spannungseinbruch in der Ausgangsspannung auszugleichen, muss die Frequenz des Eingangssignals etwas erniedrigt werden, falls der Arbeitspunkt oberhalb der Resonanzfrequenz des Transformators liegt. Somit wird ein höherer Übertragungskoeffizient eingestellt und eine höhere Ausgangsspannung erzielt. Umgekehrt muss die Frequenz des Eingangssignals etwas erhöht werden, falls der Arbeitspunkt unterhalb der Resonanzfrequenz des Transformators liegt.

Das an der Hilfselektrode abgegriffene Signal kann nicht nur zur Einstellung der Generatorfrequenz, sondern auch anderweitig, vorzugsweise als ein Steuersignal zur Einstellung der gewünschten bzw. benötigten Eingangsspannung verwendet werden.

Die Länge und/oder Breite der Hilfselektrode kann gleich der entsprechenden Abmessung einer ihr gegenüber stehenden Innenelektrode des Ein- oder Ausgangsteils gewählt sein. Die Länge und/oder Breite der Hilfselektrode kann auch kleiner oder größer als die entsprechende Abmessung dieser Innenelektrode sein.

Es ist vorteilhaft, wenn zumindest eine Kante der Hilfselektrode zum Zwecke des Kontaktierens eines Hilfskontakts bis zur Oberfläche des Grundkörpers reicht. Eine innen liegende Hilfselektrode kann in einer Variante so groß sein, dass zwei von ihren Kanten oder alle ihre Kanten bis zur Oberfläche des Grundkörpers reichen.

Der Hilfskontakt kann stirnseitig angeordnet sein. Der Hilfskontakt kann dabei auf die Stirnfläche des Grundkörpers beschränkt sein, wobei er vorzugsweise die Hilfselektrode bildet. Der Hilfskontakt kann auch kappenförmig ausgebildet sein, wobei er die Stirnseite des Grundkörpers vorzugsweise komplett bedeckt, und wobei er Bereiche aufweist, die auf den Seitenflächen und den Hauptflächen des Grundkörpers angeordnet sind.

Der Grundkörper kann z. B. quaderförmig oder - insbesondere bei einem mit Dickenschwingungen arbeitenden Transformator - zylinderförmig sein. Bei der zylindrischen Ausführung sind die Innenelektroden senkrecht zur Zylinderachse angeordnet, die parallel zur Polarisationsachse gerichtet ist. Die Hilfselektrode oder der mit einer innen liegenden Hilfselektrode verbundene Hilfskontakt kann vorteilhafterweise auf einer Stirnfläche des zylindrischen Grundkörpers angeordnet sein.

Der Grundkörper kann in einer vorteilhaften Variante flach sein, wobei seine Dicke deutlich (z. B. um mindestens Faktor vier) kleiner ist als seine Länge und Breite.

Die Eingangskontakte, die Ausgangskontakte und der mindestens eine Hilfskontakt können alle auf Seitenflächen des Grundkörpers angeordnet sein. Die Eingangskontakte sind dabei vorzugsweise auf gegenüber liegenden ersten Flächen des Grundkörpers angeordnet. Auch die Ausgangskontakte sind vorzugsweise auf gegenüber liegenden ersten Flächen des Grundkörpers angeordnet. Zumindest ein Teil des mindestens einen Hilfskontakts kann auf mindestens einer senkrecht zu den ersten Flächen liegenden zweiten Fläche des Grundkörpers angeordnet sein.

Die ersten Flächen sind vorzugsweise erste Seitenflächen des Grundkörpers. Die zweite Fläche kann z. B. eine zweite Seitenfläche oder eine Hauptfläche des Grundkörpers sein.

Die Anordnung der Hilfselektrode in einem endständigen, insbesondere stirnseitigen Teil des Grundkörpers wird als besonders vorteilhaft betrachtet. Dabei ist vorzugsweise der Eingangsteil zwischen der Hilfselektrode und dem Ausgangsteil angeordnet. Möglich ist aber auch, den Ausgangsteil zwischen der Hilfselektrode und dem Eingangsteil anzuordnen.

Die Hilfselektrode kann auch in einem Isolierteil angeordnet sein, das den Eingangsteil und den Ausgangsteil des Transformators mechanisch miteinander verbindet. Im Prinzip ist es möglich, die Hilfselektrode zwischen zwei Teilen des Eingangsteils oder Ausgangsteils des Transformators anzuordnen, wobei sie von diesen beiden Teilen galvanisch getrennt ist.

Anstelle nur einer Hilfselektrode können auch mehrere solche Elektroden vorgesehen sein, die galvanisch miteinander verbunden sind und vorzugsweise aufeinander folgen. Möglich ist aber auch, galvanisch voneinander getrennte Hilfselektroden auszubilden, die in verschiedenen Teilen des Grundkörpers angeordnet sind. Beispielsweise kann eine im Bereich des Eingangsteils angeordnete Hilfselektrode zur Überwachung des Eingangsteils und eine im Bereich des Ausgangsteils angeordnete weitere Hilfselektrode zur Überwachung des Ausgangsteils vorgesehen sein.

Der Eingangsteil ist vorzugsweise vom Ausgangsteil galvanisch getrennt. Möglich ist aber auch, dass die beiden Transformatorteile z. B. einen gemeinsamen Massekontakt aufweisen.

Im Folgenden wird der Transformator und das Verfahren zu dessen Herstellung anhand von Ausführungsbeispielen und den dazugehörigen Figuren näher erläutert. Es zeigen schematisch, in einer perspektivischen Ansicht:
Figur 1 einen beispielhaften Transformator mit einem auf seiner Seitenfläche angeordneten Hilfskontakt;
Figur 2 einen Transformator mit auf seinen Hauptflächen angeordneten Hilfskontakten;
Figur 3 einen Transformator mit einem stirnseitig angeordneten Hilfskontakt.

Dabei werden für gleiche Teile oder Teile mit gleicher oder ähnlicher Funktion die gleichen Bezugszeichen verwendet. Die Darstellungen sind nicht maßstabsgetreu.

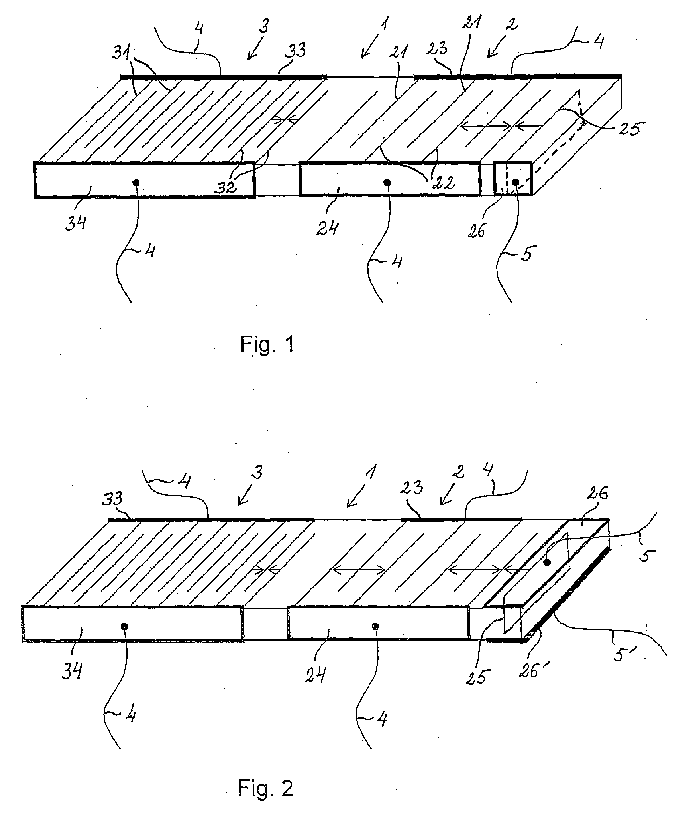

Figur 1 zeigt einen piezoelektrischen Transformator mit einem flachen Grundkörper, der aus zwei Teilen, einem Primärteil (Eingangsteil) und einem Sekundärteil (Ausgangsteil) besteht. Die beiden Teile sind mechanisch miteinander verbunden. Vorzugsweise sind Eingangsteil, Ausgangsteil und Isolierteil einstückig miteinander verbunden. Beispielsweise gelingt dies durch Übereinanderstapeln keramischer Grünfolien mit dazwischen liegenden Innenelektroden und anschließendem Sintern des Stapels, wodurch ein monolithisches Bauelement entsteht. Ein elektrisches Signal wird im Eingangsteil in mechanische Schwingungen des Transformatorkörpers umgewandelt mittels des inversen piezoelektrischen Effekts. Die mechanischen Schwingungen breiten sich durch den Körper des Transformators aus und gelangen zur Sekundärseite des Transformators, wo sie in ein elektrisches Signal zurückverwandelt werden mittels des direkten piezoelektrischen Effekts. Vorzugsweise bestehen sowohl Eingangsteil als auch Ausgangsteil aus mehreren Schichten piezoelektrischer Keramik, die durch Innenelektroden voneinander getrennt sind. Die keramischen Schichten sind dabei vorzugsweise elektrisch parallel geschaltet.

Zur galvanischen Trennung zwischen der Eingangsseite und der Ausgangsseite des Transformators ist eine Schicht aus isolierendem Material (Isolierteil) zwischen den beiden Seiten angeordnet. Diese Schicht kann beispielsweise aus demselben piezoelektrischen Material wie die übrigen Teile des Transformators bestehen. Diese Schicht kann mehrere übereinander gestapelte keramische Teilschichten umfassen.

Figur 1 zeigt einen Transformator mit einem Transformatorkörper, der ein Eingangsteil 2 und ein Ausgangsteil 3 aufweist. Die beiden Teile 2, 3 sind mittels eines Isolierteils 1 verbunden. Das Eingangsteil 2 ist mit Elektroden 21 einer ersten Sorte und mit Elektroden 22 einer zweiten Sorte versehen. Diese Elektroden 21, 22 bilden ineinander greifende Elektrodenstrukturen, mit deren Hilfe elektrische Felder im Inneren des Eingangsteils 2 erzeugt werden können. Die Elektroden 21 der ersten Sorte sind mit dem Außenkontakt 23 elektrisch kontaktiert. Die Elektroden 22 der zweite Sorte sind mit dem Außenkontakt 24 kontaktiert. In ähnlicher Weise sind im Ausgangsteil 3 des Transformators zwei Gruppen von Elektroden 31 und 32 vorgesehen, die dem Abgreifen einer elektrischen Spannung dienen, wobei die elektrische Spannung durch den mit den Elektroden 31 verbundenen Außenkontakt 33 bzw. durch den mit den Elektroden 32 verbundenen Außenkontakt 34 bewerkstelligt wird.

Im stirnseitigen Teil des Grundkörpers, im Randbereich des Eingangsteils ist eine Hilfselektrode 25 angeordnet, die an einen Hilfskontakt 26 angeschlossen ist. In der in Figur 1 gezeigten Variante ist die Hilfselektrode mit der gleichen Länge und Breite ausgebildet wie die Innenelektroden 22 des Ausgangsteils. Die Hilfselektrode 25 ist von den Außenkontakten 23, 24, 33 und 34 galvanisch getrennt.

Die Außenkontakte 23 und 24 des Eingangsteils sind auf gegenüber liegenden Seitenflächen des Grundkörpers angeordnet. Dies gilt auch für die Außenkontakte 33 und 34 des Ausgangsteils. Die Außenkontakte 24, 34 und der Hilfskontakt 26 sind an derselben Fläche - hier der vorderen Seitenfläche - des Grundkörpers angeordnet. Dabei sind die Hauptflächen und die Stirnflächen des Grundkörpers vorzugsweise metallisierungsfrei.

Die elektrischen Kontakte 23, 24, 33, 34 und 26 des Transformators werden mittels der Anschlussdrähte 4, 5 kontaktiert.

In der Variante gemäß Figur 2 ist die Hilfselektrode 25 kürzer als die Innenelektroden des Ein- bzw. Ausgangsteils ausgebildet. Die Hilfselektrode ist an einen auf einer ersten Hauptfläche des Grundkörpers angeordneten ersten Hilfskontakt 26 sowie an einen auf seiner zweiten Hauptfläche angeordneten zweiten Hilfskontakt 26' angeschlossen. Dabei bleiben die Stirnflächen des Grundkörpers vorzugsweise metallisierungsfrei. Der Kontakt 26' wird mittels eines Anschlussdrahtes 5' kontaktiert.

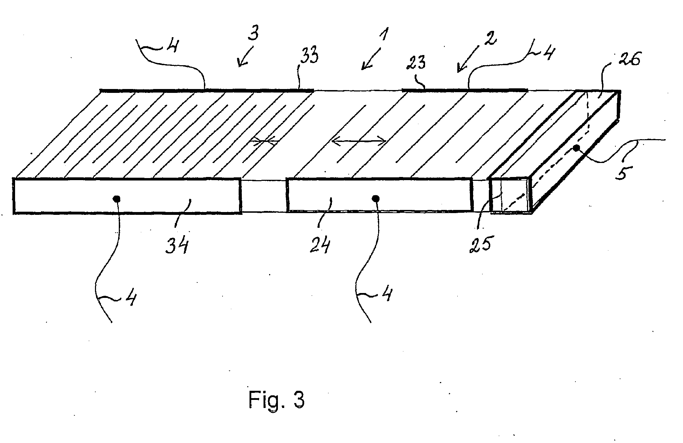

In der Variante gemäß der Figur 3 ist die Hilfselektrode 25 länger als die Innenelektroden des Ein- bzw. Ausgangsteils ausgebildet. Sie ist an einen kappenförmigen Hilfskontakt 26 angeschlossen. Ein solcher Kontakt hat den Vorteil, dass damit eine besonders große Lötfläche zum Anlöten des Anschlussdrahtes 5 zur Verfügung gestellt wird.

Bei einem Piezotransformator mit einem auf der Stirnseite des Grundkörpers ausgebildeten Hilfskontakt wie z. B. in der Variante gemäß Fig. 3 kann auf eine im Grundkörper innen liegende Hilfselektrode 25 verzichtet werden, da ein solcher Hilfskontakt an sich als eine Hilfselektrode geeignet ist.

Der angegebene Transformator ist nicht auf die in den Figuren vorgestellten Ausführungsbeispiele, die Form oder die Anzahl der schematischen dargestellten Elemente beschränkt.

### Bezugszeichenliste

- 1: Isolierteil
- 2: Eingangsteil
- 3: Ausgangsteil
- 21, 22: Innenelektroden im Eingangsteil
- 31, 32: Innenelektroden im Ausgangsteil
- 23, 24: Außenkontakte im Eingangsteil
- 33, 34: Außenkontakte im Ausgangsteil
- 25: Hilfselektrode
- 26: Hilfskontakt
- 4, 5: Anschlussdrähte

## Patentansprüche

1. Piezoelektrischer Transformator mit
- einem quaderförmigen oder zylinderförmigen Grundkörper, der eine Längsachse sowie quer zu der Längsachse angeordnete Stirnflächen aufweist und ein Material mit piezoelektrischen Eigenschaften enthält,
- einem Eingangsteil (2) in dem Grundkörper,
- einem mechanisch mit dem Eingangsteil (2) verbundenen Ausgangsteil (3) in dem Grundkörper,
- Innenelektroden (21, 22), die in dem Eingangsteil (2) senkrecht zu der Längsachse angeordnet sind,
- Außenkontakten (23, 24), die außerhalb der Stirnflächen auf dem Grundkörper angeordnet sind und wechselweise mit den Innenelektroden (21, 22) des Eingangsteils elektrisch leitend verbunden sind,
- weiteren Innenelektroden (31, 32), die in dem Ausgangsteil (3) senkrecht zu der Längsachse angeordnet sind,
- weiteren Außenkontakten (33, 34), die außerhalb der Stirnflächen auf dem Grundkörper angeordnet sind und wechselweise mit den weiteren Innenelektroden (31, 32) des Ausgangsteils elektrisch leitend verbunden sind, und
- einer Hilfselektrode (25), die senkrecht zu der Längsachse angeordnet und galvanisch von dem Eingangsteil (2) und von dem Ausgangsteil (3) getrennt ist, wobei
- die Innenelektroden (21, 22), die weiteren Innenelektroden (31, 32) und die Hilfselektrode (25) längs der Längsachse des Grundkörpers im Abstand zueinander angeordnet sind.

2. Piezoelektrischer Transformator nach Anspruch 1, bei dem die Hilfselektrode (25) zwischen den Innenelektroden (21, 22) des Eingangsteils (2) und einer der Stirnflächen des Grundkörpers angeordnet ist.

3. Piezoelektrischer Transformator nach Anspruch 1, bei dem die Hilfselektrode (25) zwischen den weiteren Innenelektroden (31, 32) des Ausgangsteils (3) und einer der Stirnflächen des Grundkörpers angeordnet ist.

4. Piezoelektrischer Transformator nach Anspruch 1, bei dem die Hilfselektrode (25) auf einer der Stirnflächen des Grundkörpers angeordnet ist.

5. Piezoelektrischer Transformator nach Anspruch 1, bei dem die Hilfselektrode (25) zwischen zwei Teilen des Eingangsteils (2) oder Ausgangsteils (3) angeordnet ist, wobei die Hilfselektrode (25) von diesen beiden Teilen galvanisch getrennt ist.

6. Piezoelektrischer Transformator nach einem der Ansprüche 1 bis 5, bei dem
die Hilfselektrode (25) mit einem auf dem Grundkörper angeordneten Hilfskontakt (26) elektrisch leitend verbunden ist.

7. Piezoelektrischer Transformator nach Anspruch 6, bei dem der Hilfskontakt (26) auf einer der Stirnflächen des Grundkörpers angeordnet ist.

8. Piezoelektrischer Transformator nach Anspruch 6, bei dem der Hilfskontakt (26) außerhalb der Stirnflächen auf dem Grundkörper angeordnet ist.

9. Piezoelektrischer Transformator nach einem der Ansprüche 1 bis 8, bei dem
der Eingangsteil (2) und der Ausgangsteil (3) durch eine ein Isolierteil (1) bildende Schicht aus isolierendem Material mechanisch miteinander verbunden sind.

10. Piezoelektrischer Transformator nach Anspruch 9, bei dem die Hilfselektrode (25) im Isolierteil (1) angeordnet ist.

11. Piezoelektrischer Transformator nach einem der Ansprüche 1 bis 10, bei dem
die Hilfselektrode (25) zur Überwachung des Eingangsteils (2) vorhanden ist,
eine weitere Hilfselektrode vorhanden ist und
die weitere Hilfselektrode zur Überwachung des Ausgangsteils (3) vorhanden ist.

## Claims

1. Piezoelectric transformer having
- a cuboid or cylindrical base body, which has a longitudinal axis as well as end surfaces arranged transversely with respect to the longitudinal axis, and contains a material with piezoelectric characteristics,
- an input part (2) in the base body
- an output part (3), which is mechanically connected to the input part (2), in the base body,
- internal electrodes (21, 22), which are arranged at right angles to the longitudinal axis in the input part (2),
- external contacts (23, 24) which are arranged on the base body outside the end surfaces and are alternately electrically conductively connected to the internal electrodes (21, 22) of the input part,
- further internal electrodes (31, 32), which are arranged at right angles to the longitudinal axis in the output part (3),
- further external contacts (33, 34), which are arranged on the base body outside the end surfaces and are alternately electrically conductively connected to the further internal electrodes (31, 32) in the output part, and
- an auxiliary electrode (25), which is arranged at right angles to the longitudinal axis and is galvanically isolated from the input part (2) and from the output part (3), wherein
- the internal electrodes (21, 22), the further internal electrodes (31, 32) and the auxiliary electrode (25) are arranged at a distance from one another along the longitudinal axis of the base body.

2. Piezoelectric transformer according to Claim 1, in which the auxiliary electrode (25) is arranged between the internal electrodes (21, 22) of the input part (2) and one of the end surfaces of the base body.

3. Piezoelectric transformer according to Claim 1, in which the auxiliary electrode (25) is arranged between the further internal electrodes (31, 32) of the output part (3) and one of the end surfaces of the base body.

4. Piezoelectric transformer according to Claim 1, in which the auxiliary electrode (25) is arranged on one of the end surfaces of the base body.

5. Piezoelectric transformer according to Claim 1, in which the auxiliary electrode (25) is arranged between two parts of the input part (2) or of the output part (3), wherein the auxiliary electrode (25) is galvanically isolated from these two parts.

6. Piezoelectric transformer according to one of Claims 1 to 5, in which
the auxiliary electrode (25) is electrically conductively connected to an auxiliary contact (26) which is arranged on the base body.

7. Piezoelectric transformer according to Claim 6, in which the auxiliary contact (26) is arranged on one of the end surfaces of the base body.

8. Piezoelectric transformer according to Claim 6, in which the auxiliary contact (26) is arranged on the base body outside the end surfaces.

9. Piezoelectric transformer according to one of Claims 1 to 8, in which
the input part (2) and the output part (3) are mechanically connected to one another by means of a layer which forms an insulation part (1) and is composed of insulating material.

10. Piezoelectric transformer according to Claim 9, in which the auxiliary electrode (25) is arranged in the insulating part (1).

11. Piezoelectric transformer according to one of Claims 1 to 10, in which
the auxiliary electrode (25) is provided in order to monitor the input part (2),
a further auxiliary electrode is provided, and
the further auxiliary electrode is provided in order to monitor the output part (3).

## Revendications

1. Transformateur piézoélectrique comprenant
- un corps de base de forme parallélépipédique ou cylindrique qui présente un axe longitudinal ainsi que des faces frontales disposées transversalement par rapport à l'axe longitudinal et qui contient un matériau ayant des propriétés piézoélectriques,
- une partie d'entrée (2) dans le corps de base,
- une partie de sortie (3) dans le corps de base reliée mécaniquement avec la partie d'entrée (2),
- des électrodes internes (21, 22) qui sont disposées dans la partie d'entrée (2) perpendiculairement à l'axe longitudinal,
- des contacts extérieurs (23, 24) qui sont disposés à l'extérieur des faces frontales sur le corps de base et qui sont reliés électriquement en alternance avec les électrodes internes (21, 22) de la partie d'entrée,
- des électrodes internes supplémentaires (31, 32) qui sont disposées dans la partie de sortie (3) perpendiculairement à l'axe longitudinal,
- des contacts extérieurs supplémentaires (33, 34) qui sont disposés à l'extérieur des faces frontales sur le corps de base et qui sont reliés électriquement en alternance avec les électrodes internes supplémentaires (31, 32) de la partie de sortie,
- une électrode auxiliaire (25) qui est disposée perpendiculairement à l'axe longitudinal et qui est séparée galvaniquement de la partie d'entrée (2) et de la partie de sortie (3),
- les électrodes internes (21, 22), les électrodes internes supplémentaires (31, 32) et l'électrode auxiliaire (25) étant disposées le long de l'axe longitudinal du corps de base en étant espacées les unes des autres.

2. Transformateur piézoélectrique selon la revendication 1, dans lequel l'électrode auxiliaire (25) est disposée entre les électrodes internes (21, 22) de la partie d'entrée (2) et l'une des faces frontales du corps de base.

3. Transformateur piézoélectrique selon la revendication 1, dans lequel l'électrode auxiliaire (25) est disposée entre les électrodes internes supplémentaires (31, 32) de la partie de sortie (3) et l'une des faces frontales du corps de base.

4. Transformateur piézoélectrique selon la revendication 1, dans lequel l'électrode auxiliaire (25) est disposée sur l'une des faces frontales du corps de base.

5. Transformateur piézoélectrique selon la revendication 1, dans lequel l'électrode auxiliaire (25) est disposée entre deux parties de la partie d'entrée (2) ou de la partie de sortie (3), l'électrode auxiliaire (25) étant séparée galvaniquement de ces deux parties.

6. Transformateur piézoélectrique selon l'une des revendications 1 à 5, dans lequel l'électrode auxiliaire (25) est reliée électriquement avec un contact auxiliaire (26) disposé sur le corps de base.

7. Transformateur piézoélectrique selon la revendication 6, dans lequel le contact auxiliaire (26) est disposé sur l'une des faces frontales du corps de base.

8. Transformateur piézoélectrique selon la revendication 6, dans lequel le contact auxiliaire (26) est disposé en dehors des faces frontales sur le corps de base.

9. Transformateur piézoélectrique selon l'une des revendications 1 à 8, dans lequel la partie d'entrée (2) et la partie de sortie (3) sont reliées ensemble mécaniquement par une couche en matériau isolant qui forme une partie isolante (1).

10. Transformateur piézoélectrique selon la revendication 9, dans lequel l'électrode auxiliaire (25) est disposée dans la partie isolante (1).

11. Transformateur piézoélectrique selon l'une des revendications 1 à 10, dans lequel l'électrode auxiliaire (25) est présente pour surveiller la partie d'entrée (2), il existe une électrode auxiliaire supplémentaire et l'électrode auxiliaire supplémentaire est présente pour surveiller la partie de sortie (3).
